Europäisches Patentamt

European Patent Office

Office européen des brevets

(11) Publication number: **0 029 700**
**B1**

(12) **EUROPEAN PATENT SPECIFICATION**

(45) Date of publication of patent specification: **09.11.83**

(51) Int. Cl.³: **H 03 K 13/17**

(21) Application number: **80304131.8**

(22) Date of filing: **18.11.80**

(54) **Analog-to-digital converter.**

| | |
|---|---|
| (30) Priority: **24.11.79 JP 152257/79** | (73) Proprietor: **FUJITSU LIMITED**<br>**1015, Kamikodanaka Nakahara-ku**<br>**Kawasaki-shi Kanagawa 211 (JP)** |
| (43) Date of publication of application:<br>**03.06.81 Bulletin 81/22** | (72) Inventor: **Tamada, Haruo**<br>**497-28-19-24, Kawakami-cho**<br>**Totsuka-ku, Yokohama-shi Kanagawa 244 (JP)** |
| (45) Publication of the grant of the patent:<br>**09.11.83 Bulletin 83/45** | **Inventor: Kudo, Osamu**<br>**44-5, Kitamagome 2-chome**<br>**Ohta-ku, Tokyo 143 (JP)** |
| (84) Designated Contracting States:<br>**DE FR GB NL** | (74) Representative: **Abbott, Leonard Charles et al,**<br>**GILL JENNINGS & EVERY 53-64 Chancery Lane**<br>**London WC2A 1HN (GB)** |
| (56) References cited:<br>**DE - B - 1 207 642**<br>**US - A - 3 882 484**<br>**US - A - 4 035 784** | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Analog-to-digital converter

This invention relates to an analog-to-digital converter of the type using a differential amplifier and a digital-to-analog converter.

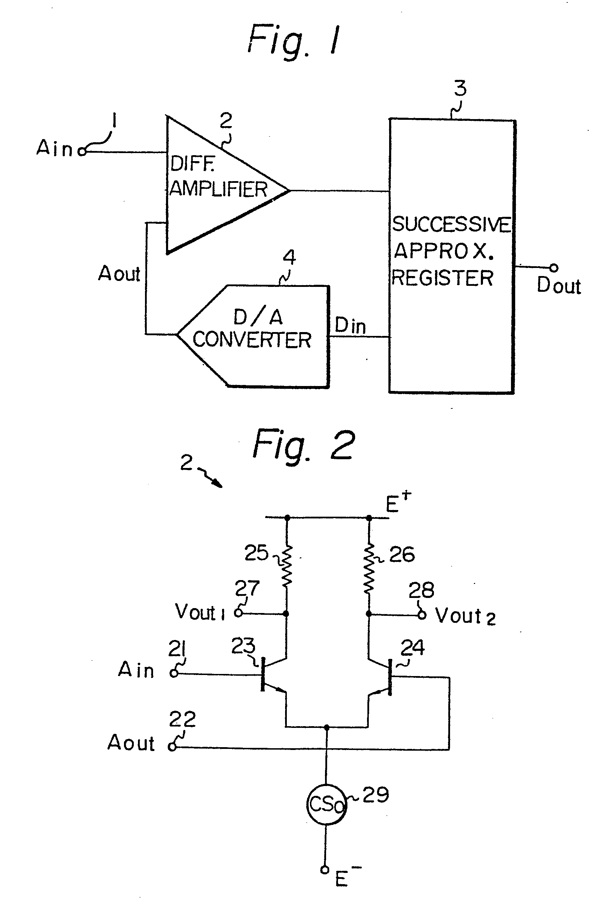

A known analog-to-digital converter of the above type, as illustrated in Fig. 1 of the accompanying drawings, comprises a differential amplifier 2 to which are supplied an analog input $A_{in}$, and an analog output $A_{out}$ of a digital-to-analog converter 4. A successive approximation register 3 receives the output of the differential amplifier 2 and supplies an output to the digital-to-analog converter 4. The circuit of the differential amplifier 2 is illustrated in Fig. 2. It comprises a pair of emitter-connected transistors 23 and 24, load resistors 25 and 26 and a current source ($CS_0$) 29. A voltage $V_{in}$ applied across the input terminals 21 and 22 is equal to the difference $A_{in}-A_{out}$, where $A_{in}$ is the signal applied to a first input terminal 21 and $A_{out}$ is the signal applied to a second input terminal 22.

In the known analog-to-digital-converters, a differential amplifier is used in which the structure and the operative characteristic of the transistor 23 are the same as those of the transistor 24. The resistance of the resistor 25 is the same as that of the resistor 26. The two inputs which are to be compared are supplied to the input terminals 21 and 22. The differential amplifier 2 produces an output $V_{out}$ which is the difference between the potential $V_{out\ 1}$ at the terminal 27 and the potential $V_{out\ 2}$ at the terminal 28.

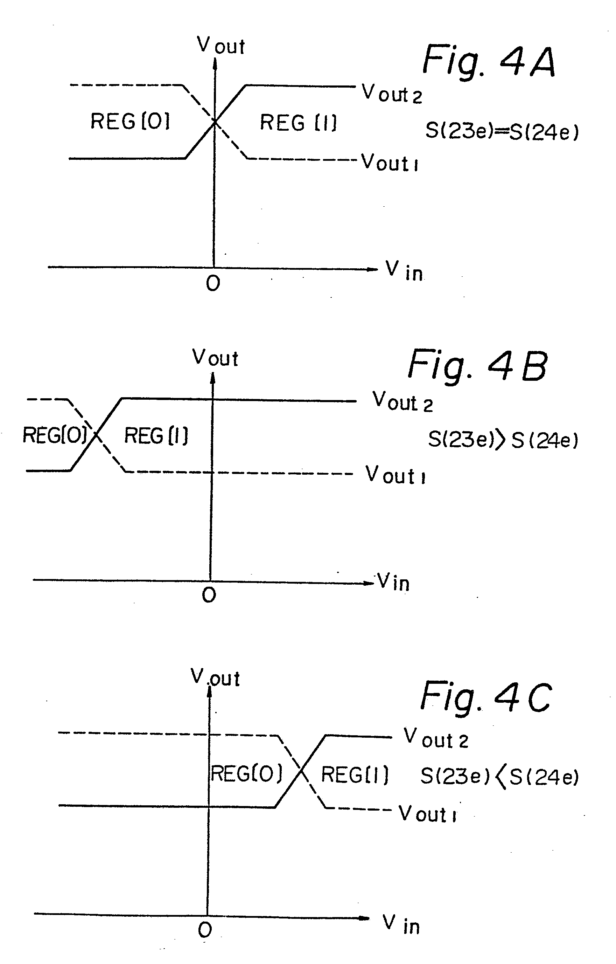

The relationship between the voltage difference $V_{in}$ between the inputs and the output voltage $V_{out}$ of the differential amplifier 2 in the known analog-to-digital converters is illustrated in Fig. 4A.

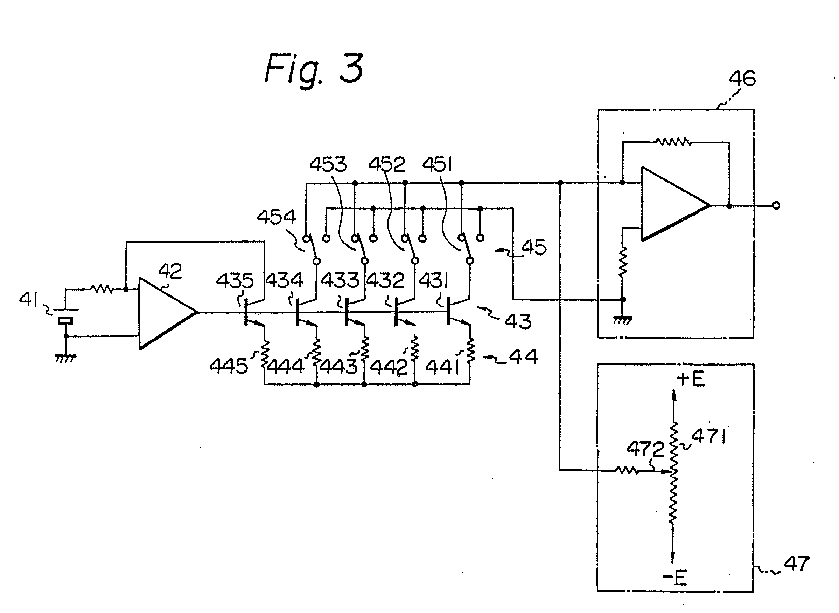

In prior art analog-to-digital converters of the type shown in Fig. 1, a digital-to-analog converter as illustrated in Fig. 3 is used in order to obtain the offset characteristic of the digital-to-analog converter. The digital-to-analog converter of Fig. 3 comprises a reference voltage source 41, a control amplifier 42, a set of transistors 43, a set of resistors 44, a set of switches 45, a current-to-voltage converter 46 and an offset control circuit 47. The offset control circuit 47 consists of a potentiometer 471. The digital-to-analog converter of Fig. 3 has the offset characteristic because of the existence of the offset control circuit 47.

However, the use of the digital-to-analog converter of Fig. 3 is disadvantageous, because it is necessary to provide the offset control circuit and it is also necessary to carry out the adjustment of the offset control circuit by adjusting the position of the slider 472 on the potentiometer 471.

Another prior analog-to-digital converter is disclosed in United States Patent No. 3,882,484. That converter comprises a comparator including two transistors connected to form a differential amplifier. A register controls a digital-to-analog converter, the output of which is applied to one input of the differential amplifier. Offset in the digital-to-analog converter and in the differential amplifier is provided by an offset generator. Offset in the differential amplifier is also provided by a potentiometer which differentially adjusts the emitter currents of the two transistors of the amplifier.

That prior analog-to-digital converter therefore has the disadvantages that, for setting the overall offset characteristic of the converter, it requires the provision of a separate generator for applying an offset voltage to the differential amplifier, and also a potentiometer which has to be set to provide amplifier offset.

It is an object of the present invention to overcome the above-mentioned disadvantages of the prior analog-to-digital converters.

Prior art digital-to-analog converters for a successive approximation analog-to-digital converter are described in, for example, "Data Acquisition Products Catalog 1978", pages 289 to 294, published by ANALOG DEVICES Company.

In accordance with one aspect of the present invention there is provided an analog-to-digital converter comprising a differential amplifier including two transistors connected in differential relationship; a register; a digital-to-analog converter for converting the digital output signal of the register, the analog output signal of the digital-to-analog converter being applied to one input terminal of the differential amplifier; and means to provide a predetermined offset in the overall analog-to-digital conversion characteristic; characterised in that the emitter area of one of the transistors is different from that of the other transistor so that the analog-to-digital converter operates with the predetermined offset in the overall analog-to-digital conversion characteristic without requiring application of an offset reference voltage to the differential amplifier.

In accordance with another aspect of the invention there is provided an analog-to-digital converter comprising a differential amplifier including a pair of transistors connected in differential relationship; a register; a digital-to-analog converter for converting the digital output signal of the register, the analog output signal of the digital-to-analog converter being applied to one input terminal of the differential amplifier; and means to provide a predetermined offset in the overall analog-to-digital conversion characteristic; characterised in that the differential amplifier further includes additional transistors for controlling the base currents of the pair of transistors; and in that the density of the emitter current of one of the additional transistors is made different from that of the other additional transistor so that the analog-to-digital converter operates with the predetermined offset in the overall analog-to-digital conversion characteristic without requiring application of an offset reference voltage to the differential amplifier.

Embodiments of the invention will now be described, by way of example, with reference to the accompanying drawings, in which:

Fig. 1 illustrates, schematically, an analog-to-digital converter comprising a differential amplifier, a register and a digital-to-analog converter,

Fig. 2 is a circuit diagram of the differential amplifier used in the converter of Fig. 1,

Fig. 3 is a circuit diagram of the digital-to-analog converter used in a prior art analog-to-digital converter of the type shown in Fig. 1,

Figs. 4A, 4B and 4C illustrate the relationships between $V_{in}$ and $V_{out}$ of the differential amplifier,

Figs. 5A, 5B and 5C illustrate the operating characteristics of the prior art analog-to-digital converter,

Fig. 6 illustrates the structure of the differential amplifier used in an analog-to-digital converter in accordance with the present invention.

Figs. 7A, 7B and 7C illustrate the operating characteristics of the analog-to-digital converter of the present invention, and

Fig. 8 illustrates another example of a differential amplifier used in an embodiment of the present invention.

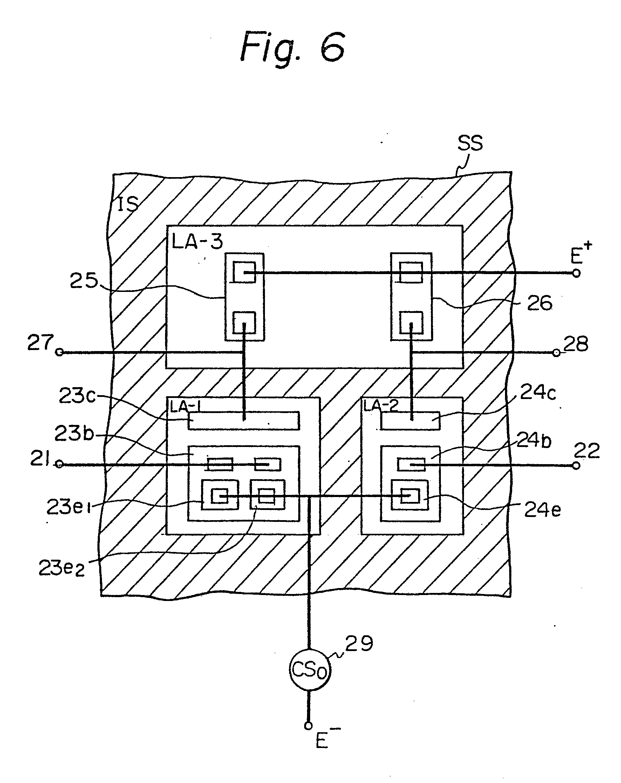

An analog-to-digital converter in accordance with the present invention is illustrated in Figs. 1, 2 and 6. It should be noted that the basic arrangement of the analog-to-digital converter and the differential amplifier in accordance with the present invention can be the same as that of the analog-to-digital converter described earlier in the present specification with reference to Figs. 1 and 2. The transistors 23 and 24 used in the differential amplifier have the structure illustrated in Fig. 6.

The transistors 23 and 24 are formed in land portions LA-1 and LA-2 in a semiconductor substrate SS. The land portions LA-1 and LA-2 are separated by an isolation portion IS. The transistor 23 comprises a base region 23b, emitter regions 23e1 and 23e2, a collector region 23c and an input connection 21. The transistor 24 comprises a base region 24b, an emitter region 24e, a collector region 24c and an input connection 22.

In the structure of Fig. 6, each of the emitter areas 23e1 and 23e2 is the same as the emitter area 24e, and hence the total emitter area of the transistor 23 is twice the emitter area of the transistor 24.

From the diode characteristic between the base and the emitter of each of the transistors 23 and 24, the offset input voltage $V_{in}(OFS)$ which causes the output $V_{out}$ of the differential amplifier 2 to be zero (i.e. $V_{out}=V_{out\,1}-V_{out\,2}=0$) is represented as follows.

$$V_{in}(OFS)=\frac{kT}{q}\ln\frac{\dfrac{I_1}{S(23e)}}{\dfrac{I_2}{S(24e)}} \qquad (1)$$

In equation (1), $I_1$ and $I_2$ are the currents passing through the resistors 25 and 26, respectively, S(23e) and S(24e) are the emitter areas of the transistors 23 and 24, k is the Boltzmann Constant, T is the absolute temperature and q is the charge.

In accordance with equation (1), it is possible to obtain a fixed value of the offset voltage $V_{in}(OFS)$ by selecting the ratio between the current density

$$\frac{I_1}{S(23e)}$$

of the emitter current of the transistor 23 and the current density

$$\frac{I_2}{S(24e)}$$

of the emitter current of the transistor 24.

If the currents $I_1$ and $I_2$ are equal, equation (1) is represented as follows.

$$V_{in}(OFS)=\frac{kT}{q}\ln\frac{S(24e)}{S(23e)} \qquad (2)$$

For example, in the embodiment of Fig. 6, it is possible to obtain a fixed value of the offset voltage $V_{in}(OFS)$ as represented by equation (2), because the ratio between S(24e) and S(23e) is equal to 1:2.

Accordingly, the relationship between the input voltage difference $V_{in}$ and the output voltage $V_{out}$ of the differential amplifier 2 is illustrated in Fig. 4B. On the other hand, if the emitter area of the transistor 24 is greater than that of the transistor 23, the relationship will be as illustrated in Fig. 4C.

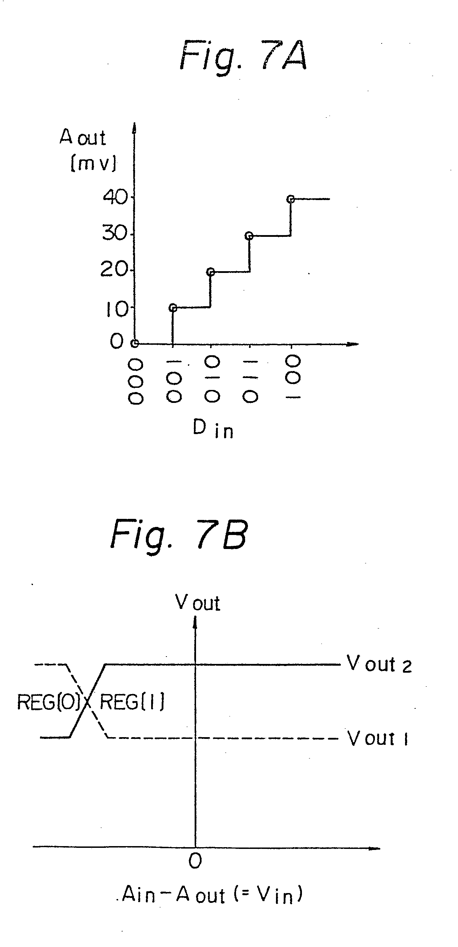

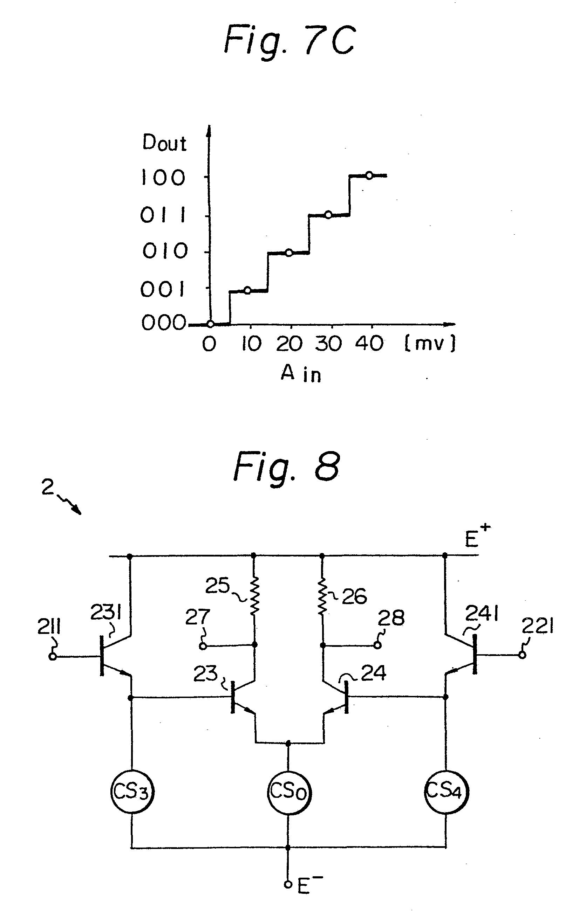

When the differential amplifier having the structure of Fig. 6 is used for the differential amplifier 2 of the analog-to-digital converter of Fig. 1, the operating characteristics of the elements of the analog-to-digital converter illustrated in Figs. 7A, 7B and 7C are obtained. The relationship between the digital input $D_{in}$ and the analog output $A_{out}$ of the digital-to-analog converter 4 is illustrated in Fig. 7A. The relationship between the value $A_{in}-A_{out}$, which is equal to $V_{in}$, and the value $V_{out}$ in the differential amplifier 2 is illustrated in Fig. 7B. In the region REG[O], the differential amplifier 2 produces the output signal "O", while, in the region REG[1], the differential amplifier 2 produces the output signal "1".

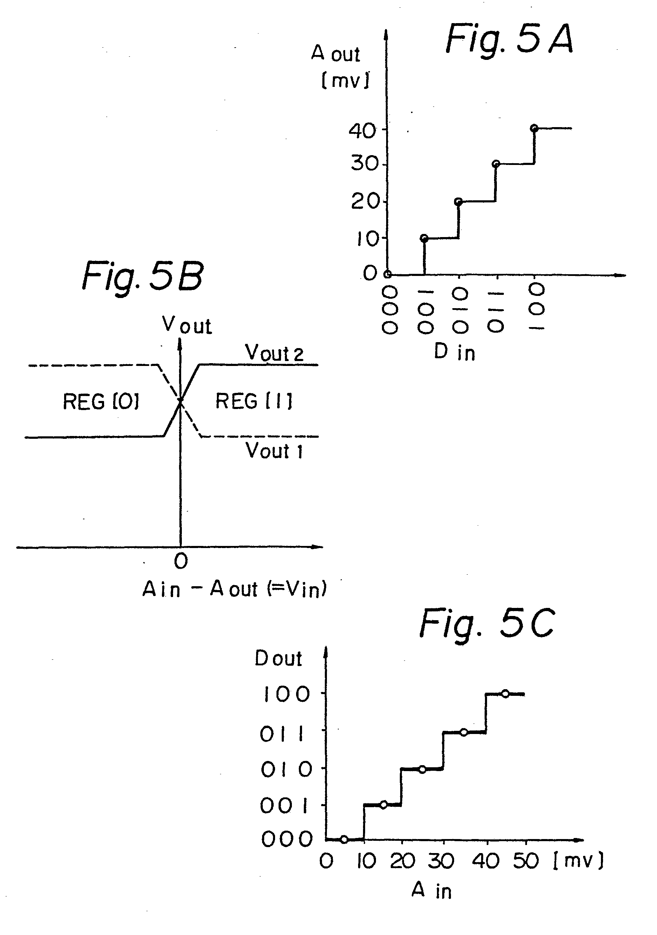

As a result of combining the characteristics of Fig. 7A with the characteristics of Fig. 7B, the resultant characteristic between the analog input $A_{in}$ and the digital output $D_{out}$ of the analog-to-digital converter of Fig. 1, illustrated in Fig. 7C, is obtained. It can be seen in Fig. 7C that the staircase line is shifted to the left by 5 mV compared with the staircase line in Fig. 5C which is obtained by using the characteristic of Fig. 5B to which the present invention is applied.

Another example of a differential amplifier for use in the analog-to-digital converter of Fig. 1 is illustrated in Fig. 8. In the circuit of Fig. 8, a third transistor 231 and a fourth transistor 241 are provided in addition to the first and second transistors 23 and 24. Also, additional current sources $CS_3$ and $CS_4$ are provided in the circuit of Fig. 8.

The offset input voltage $V_{in}(OFS)$ which causes the output $V_{out}$ of the differential amplifier 2 to be zero (i.e. $V_{out}=V_{out\ 1}-V_{out\ 2}=O$) is represented as follows.

$$V_{in}(OFS)=\frac{kT}{q}\ \ln\ \frac{\dfrac{I_3}{S(231e)}}{\dfrac{I_4}{S(241e)}} \qquad (3)$$

In equation (3), $I_3$ and $I_4$ are the currents passing through the current sources $CS_3$ and $CS_4$, respectively, $S(231e)$ and $S(241e)$ are the emitter areas of the transistors 231 and 241, k is the Boltzmann Constant, T is the absolute temperature and q is the charge.

In accordance with equation (3), it is possible to obtain a fixed value of the offset voltage $V_{in}(OFS)$ by selecting the ratio between the current density

$$\frac{I_3}{S(231e)}$$

of the emitter current of the transistor 231 and the current density

$$\frac{I_4}{S(241e)}$$

of the emitter current of the transistor 241. Such selection can be carried out by selecting the ratio between $I_3$ and $I_4$ under the condition $S(231e)=S(241e)$, selecting the ratio between $S(231e)$ and $S(241e)$ under the condition $I_3=I_4$ or selecting both the ratio between $I_3$ and $I_4$ and the ratio between $S(231e)$ and $S(241e)$.

## Claims

1. An analog-to-digital converter comprising a differential amplifier (2) including two transistors (23, 24) connected in differential relationship; a register (3); a digital-to-analog converter (4) for converting the digital output signal of the register, the analog output signal of the digital-to-analog converter being applied to one input terminal of the differential amplifier; and means to provide a predetermined offset in the overall analog-to-digital conversion characteristic; characterised in that the emitter area of one of the transistors (23) is different from that of the other transistor (24) so that the analog-to-digital converter operates with the predetermined offset in the overall analog-to-digital conversion characteristic without requiring application of an offset reference voltage to the differential amplifier (2).

2. An analog-to-digital converter comprising a differential amplifier (2) including a pair of transistors (23, 24) connected in differential relationship; a register (3); a digital-to-analog converter (4) for converting the digital output signal of the register, the analog output signal of the digital-to-analog converter being applied to one input terminal of the differential amplifier; and means to provide a predetermined offset in the overall analog-to-digital conversion characteristic; characterised in that the differential amplifier further includes additional transistors (231, 241) for controlling the base currents of the pair of transistors; and in that the density of the emitter current of one of the additional transistors (231) is made different from that of the other additional transistor (241) so that the analog-to-digital converter operates with the predetermined offset in the overall analog-to-digital conversion characteristic without requiring application of an offset reference voltage to the differential amplifier (2).

3. An analog-to-digital converter as claimed in Claim 2, characterised in that the difference in emitter current densities is achieved by providing different emitter areas for the respective transistors (231, 241).

## Patentansprüche

1. Analog-Digital-Umsetzer, mit einem Differentialverstärker (2), welcher zwei Transistoren (23, 24) umfaßt, die in differentieller Relation zueinander angeschlossen sind, einem Register (3), einem Digital-Analog-Umsetzer (4) zur Umsetzung des digitalen Ausgangssignals des Registers, wobei das analoge Ausgangssignal des Digital-Analog-Umsetzers einem Eingangsanschluß des Differentialverstärkers zugeführt wird, und mit Einrichtungen zur Erzeugung eines vorbestimmten Versetzungssignals in der gesamten Analog-Digital-Umsetzungscharakteristik, dadurch gekennzeichnet, daß der Emitterbereich des einen Transistors (23) unterschiedlich von dem des anderen Transistors (24) ist, so daß der Analog-Digital-Umsetzer mit einer vorbestimmten Versetzung in der gesamten Analog-Digital-Umwandlungscharakteristik arbeitet, ohne die Anwendung von einer Versetzungsreferenzspannung zu dem Differentialverstärker (2) zu erfordern.

2. Analog-Digital-Umsetzer, mit einem Differentialverstärker (2), welcher zwei Transistoren (23, 24) umfaßt, die in differentieller Relation zueinander angeschlossen sind, einem Register (3), einem Digital-Analog-Umsetzer (4) zur Umsetzung des digitalen Ausgangssignals des Registers, wobei das analoge Ausgangssignal des Digital-Analog-Umsetzers einem Eingangsanschluß des Differentialverstärkers zugeführt wird, und mit Einrichtungen zur Erzeugung eines vorbestimmten Versetzungssignals in der gesamten Analog-Digital-Umsetzungscharakteristik, dadurch gekennzeichnet, daß der Differentialverstärker ferner zusätzliche Transistoren (231, 241) zur Steuerung der Basisströme des Transistorpaars umfaßt, und daß die Dichte des Emitterstroms von einem der zusätzlichen Transistoren (231) unterschiedlich von derjenigen des anderen zusätzlichen Transistors (241) gemacht ist, so daß der Analog-Digital-Umsetzer mit der vorbestimmten Versetzung in der gesamten Analog-Digital-Umsetzungscharakteristik arbeitet, ohne die Anwendung einer Versetzungereferenzspannung zu dem Differentialverstärker (2) zu erfordern.

3. Analog-Digital-Umsetzer nach Anspruch 2, dadurch gekennzeichnet, daß die Differenz der Emitterstromdichten durch Vorsehung unterschiedlicher Emitterbereiche für die entsprechenden Transistoren (231, 241) erreicht ist.

## Revendications

1. Convertisseur analogique-numérique comprenant un amplificateur différentiel (2) comportant deux transistors (23, 24) connectés de manière différenteille; un registre (3); un convertisseur numérique-analogique (4) servant à convertir le signal de sortie numérique du registre, le signal de sortie analogique du convertisseur numérique-analogique étant applique à une première borne d'entrée de l'amplificateur différentiel; et un moyen permettant de produire un décalage prédéterminé dans le caractéristique de conversion analogique-numérique globale; caractérisé en ce que l'aire d'émetteur de l'un (23) des transistors est différente de celle de l'autre transistor (24) si bien que le convertisseur analogique-numérique fonctionne avec le décalage prédéterminé de la caractéristique de conversion analogique-numérique globale sans qu'il soit besoin d'appliquer une tension de référence de décalage à l'amplificateur différentiel (2).

2. Convertisseur analogique-numérique comprenant un amplificateur différentiel (2) comportant une paire de transistors (23, 24) connectés de manière différentielle; un registre (3); un convertisseur numérique-analogique (4) servant à convertir le signal de sortie numérique du registre, le signal de sortie analogique du convertisseur numérique-analogique étant appliqué à une première borne d'entrée de l'amplificateur différentiel; et un moyen permettant de produire un décalage prédéterminé dans la caractéristique de conversion analogique-numérique globale; caractérisé en ce que l'amplificateur différentiel comporte en outre des transistors supplémentaires (231, 241) servant à commander les courants de base de la paire de transistors; et en ce que le densité du courant d'émetteur de l'un (231) des transistors supplémentaires est rendue différente de celle de l'autre transistor supplémentaire (241), si bien que le convertisseur analogique-numérique fonctionne avec le décalage prédéterminé de la caractéristique de conversion analogique-numérique globale sans qu'il soit besoin d'appliquer une tension de référence de décalage à l'amplificateur différentiel (2).

3. Convertisseur analogique-numérique selon la revendication 2, caractérisé en ce que la différence des densités de courant d'émetteur est obtenue au moyen d'aires d'émetteur différentes pour les transistors respectifs (231, 241).

# Fig. 1

# Fig. 2

Fig. 3

Fig. 4A

$V_{out}$

$V_{out2}$

REG [0]   REG [1]

$S(23e) = S(24e)$

$V_{out1}$

O   $V_{in}$

Fig. 4B

$V_{out}$

$V_{out2}$

REG[0]   REG [1]

$S(23e) > S(24e)$

$V_{out1}$

O   $V_{in}$

Fig. 4C

$V_{out}$

$V_{out2}$

REG[0]   REG[1]   $S(23e) < S(24e)$

$V_{out1}$

O   $V_{in}$

Fig. 5A

Fig. 5B

Fig. 5C

## Fig. 6

## Fig. 7A

## Fig. 7B

# Fig. 7C

# Fig. 8